# EUROPEAN PATENT APPLICATION

(11) **EP 4 207 268 A1**
(43) Date of publication of application: **05.07.2023**
(21) Application number: 20954534.2
(22) Date of filing: 25.09.2020
(51) Int. Cl.: H01L 23/31, H01L 23/13, H01L 21/50

(54) **PACKAGING STRUCTURE, PACKAGING METHOD, ELECTRONIC DEVICE AND MANUFACTURING METHOD THEREFOR**

(71) Applicant: Huawei Technologies Co., Ltd., Shenzhen, Guangdong 518129 (CN)
(72) Inventor: WU, Weiche, Shenzhen, Guangdong 518129 (CN); REN, Yiwei, Shenzhen, Guangdong 518129 (CN); ZHAO, Nan, Shenzhen, Guangdong 518129 (CN); ZHENG, Jiantao, Shenzhen, Guangdong 518129 (CN); CHIANG, Shanghsuan, Shenzhen, Guangdong 518129 (CN); JIANG, Yu, Shenzhen, Guangdong 518129 (CN); HU, Xiao, Shenzhen, Guangdong 518129 (CN)
(74) Representative: Gill Jennings & Every LLP
(86) International application number: PCT/CN2020/117570
(87) International publication number: WO 2022/061682

(57) **Abstract**

A packaging structure, a packaging method, an electronic apparatus, and a manufacturing method thereof are provided. The packaging structure includes a packaging substrate (100), a chip (200), and a reinforcing apparatus (310), where the chip is fastened to the packaging substrate, the reinforcing apparatus is fastened to the packaging substrate at a periphery of the chip, the reinforcing apparatus includes at least a ring structure that transversely surrounds the chip, a side, facing the packaging substrate, of the reinforcing apparatus has a bonding plane (301) and a plurality of bumps (302/303) protruding out of the bonding plane, the plurality of bumps are disposed at different positions of the ring structure to support the reinforcing apparatus on the packaging substrate, and the bonding plane and the packaging substrate are bonded by using insulating adhesive (102).

## Description

### TECHNICAL FIELD

This application relates to the field of semiconductor manufacturing technologies, and in particular, to a packaging structure, a packaging method, an electronic apparatus, and a manufacturing method thereof.

### BACKGROUND

Manufactured chips can be used only after being packaged. A flip chip (Flip Chip) technology is a chip interconnection technology, and is also an ideal chip bonding technology. A chip may be flip-packaged on a packaging substrate, and a connection end of the chip is led out by using the packaging substrate to package the chip.

With sharply increasing requirements of high-speed data communication and artificial intelligence for computing power, chip integration is further improved, and a package size is also increased accordingly. As a result, packaging warpage caused by a mismatch of coefficients of thermal expansion (cCTE) between a chip and a packaging substrate is increasingly obvious, and consequently, control on packaging thermal deformation is more difficult. The packaging warpage may easily cause problems such as solder bridging and open soldering between the chip and the packaging substrate, which seriously affects a yield of a surface mounted technology (SMT).

To control the packaging thermal deformation, a reinforcing apparatus may be disposed on the packaging substrate. The reinforcing apparatus may be fastened to the packaging substrate, to relieve warpage of the packaging substrate. However, the reinforcing apparatus may also increase an internal stress of a packaging structure while relieving the warpage of the packaging substrate, and a problem such as layering or fracture may easily occur at a position with a large stress. Therefore, reliability of the packaging structure is low.

### SUMMARY

In view of this, this application provides a packaging structure, a packaging method, an electronic apparatus, and a manufacturing method thereof, to relieve warpage of a packaging substrate, control an internal stress of the packaging structure, and improve reliability of the packaging structure.

A first aspect of embodiments of this application provides a packaging structure, including a packaging substrate, a chip, and a reinforcing apparatus, where the chip is fastened to the packaging substrate, the reinforcing apparatus is fastened to the packaging substrate at a periphery of the chip, the reinforcing apparatus includes at least a ring structure that transversely surrounds the chip, a side, facing the packaging substrate, of the reinforcing apparatus has a bonding plane and a plurality of bumps protruding out of the bonding plane, the plurality of bumps are disposed at different positions of the ring structure to support the reinforcing apparatus on the packaging substrate, and the bonding plane and the packaging substrate are bonded by using insulating adhesive.

In this embodiment of this application, because the height difference between the bonding plane and the bumps is definite, and the bumps may support the reinforcing apparatus on the packaging substrate, the distance between the bonding plane and the packaging substrate is also definite. This helps accurately control a thickness of the insulating adhesive between the bonding plane and the packaging substrate, and resolves packaging reliability problems caused by inaccurate control on the thickness of the insulating adhesive, for example, a problem of a large stress caused by a thin insulating adhesive, and a problem of serious warpage of a packaging structure caused by a thick insulating adhesive.

In some possible implementations, the ring structure is a rectangular ring structure, and the bumps are located at corners of the rectangular ring structure, and/or are located on sides of the rectangular ring structure.

In this embodiment of this application, the reinforcing apparatus may include a rectangular ring structure, and the bumps may be disposed at corners of the rectangular ring structure and/or on sides of the rectangular ring structure, so as to provide a stable support function for the reinforcing apparatus and facilitate manufacturing.

In some possible implementations, projections of the bumps on a surface of the packaging substrate are in at least one of the following shapes: a polygon, a circle, an ellipse, an L shape, and a cross shape.

In this embodiment of this application, the projections of the bumps on the surface of the packaging substrate may be in various shapes, so as to provide a stable support function for the reinforcing apparatus and facilitate manufacturing.

In some possible implementations, a height range of the bumps relative to the bonding plane is 10 micrometers to 300 micrometers.

In this embodiment of this application, the height range of the bump relative to the bonding plane is 10 micrometers to 300 micrometers, and the bumps support the reinforcing apparatus on the packaging substrate. In this way, a distance range between the bonding plane and the packaging substrate is 10 micrometers to 300 micrometers, and a thickness range of the insulating adhesive between the bonding plane and the packaging substrate is also approximately limited within the range, thereby accurately controlling the thickness of the insulating adhesive.

In some possible implementations, the reinforcing apparatus further includes a heat dissipation plane connected to the ring structure, and the heat dissipation plane is located above the chip and is used for dissipating heat for the chip.

In this embodiment of this application, the reinforcing apparatus may further include a heat dissipation plane connected to the ring structure, and the heat dissipation plane is located above the chip and is used for dissipating heat for the chip. In this way, the reinforcing apparatus may implement both functions of stress relief and heat dissipation, thereby improving structural stability and functional stability of the packaging structure.

In some possible implementations, a thermal interface material is disposed between the heat dissipation plane and the chip.

In this embodiment of this application, the thermal interface material is disposed between the heat dissipation plane and the chip, and the thermal interface material may conduct heat generated by the chip to the heat dissipation plane, thereby improving heat dissipation efficiency of the heat dissipation plane for the chip, achieving an effect of fastening the heat dissipation plane and the chip, and providing structural stability of the packaging structure.

In some possible implementations, the thermal interface material is a colloid including thermally conductive particles, and the thermally conductive particles include at least one of zinc oxide, aluminum oxide, aluminum nitride, boron nitride, and a ceramic filler.

In this embodiment of this application, the thermal interface material may be a colloid including thermally conductive particles. The thermally conductive particles may perform a heat conduction function, and the colloid may perform a bonding function, to improve structural stability and functional stability of the packaging structure.

A second aspect of embodiments of this application provides an electronic apparatus, including:
a printed circuit board and the packaging structure according to the first aspect of embodiments of this application, where the packaging substrate is fastened to the printed circuit board, and the printed circuit board and the chip are electrically connected by using the packaging substrate.

A third aspect of embodiments of this application provides a packaging method, including:
providing a packaging substrate, where a chip is fastened to the packaging substrate; and
fastening a reinforcing apparatus to the packaging substrate at a periphery of the chip by using insulating adhesive, where the reinforcing apparatus includes at least a ring structure that transversely surrounds the chip, a side, facing the packaging substrate, of the reinforcing apparatus has a bonding plane and a plurality of bumps protruding out of the bonding plane, the plurality of bumps are disposed at different positions of the ring structure to support the reinforcing apparatus on the packaging substrate, and the bonding plane and the packaging substrate are bonded by using the insulating adhesive.

In some possible implementations, the fastening a reinforcing apparatus to the packaging substrate at a periphery of the chip by using insulating adhesive includes:
forming the insulating adhesive at a position of the packaging substrate corresponding to the bonding plane; and
press-fitting the reinforcing apparatus to the packaging substrate in a pressure control manner, so that the bumps support the reinforcing apparatus on the packaging substrate, and the bonding plane and the packaging substrate are bonded by using the insulating adhesive.

In some possible implementations, the ring structure is a rectangular ring structure, and the bumps are located at corners of the rectangular ring structure, and/or are located on sides of the rectangular ring structure.

In some possible implementations, projections of the bumps on a surface of the packaging substrate are in at least one of the following shapes: a polygon, a circle, an ellipse, an L shape, and a cross shape.

In some possible implementations, a height range of the bumps relative to the bonding plane is 10 micrometers to 300 micrometers.

In some possible implementations, the reinforcing apparatus further includes a heat dissipation plane connected to the ring structure, and the heat dissipation plane is located above the chip and is used for dissipating heat for the chip.

In some possible implementations, a thermal interface material is disposed between the heat dissipation plane and the chip.

In some possible implementations, the thermal interface material is a colloid including thermally conductive particles, and the thermally conductive particles include at least one of zinc oxide, aluminum oxide, aluminum nitride, boron nitride, and a ceramic filler.

In some possible implementations, a flip chip ball grid array packaging form is used between the packaging substrate and the chip.

A fourth aspect of embodiments of this application provides a manufacturing method for an electronic apparatus, including:
fastening the packaging substrate in the packaging structure provided in the first aspect of embodiments of this application to a printed circuit board, where the printed circuit board and the chip are electrically connected by using the packaging substrate.

According to the foregoing technical solutions, it can be learned that embodiments of this application have the following advantages.

Embodiments of this application provide a packaging structure, a packaging method, an electronic apparatus, and a manufacturing method thereof. The packaging structure includes a packaging substrate, a chip, and a reinforcing apparatus, where the chip is fastened to the packaging substrate, the reinforcing apparatus is fastened to the packaging substrate at a periphery of the chip, the reinforcing apparatus includes at least a ring structure that transversely surrounds the chip, a side, facing the packaging substrate, of the reinforcing apparatus has a bonding plane and a plurality of bumps protruding out of the bonding plane, the plurality of bumps are disposed at different positions of the ring structure to support the reinforcing apparatus on the packaging substrate, and the bonding plane and the packaging substrate are bonded by using insulating adhesive. Because the height difference between the bonding plane and the bumps is definite, and the bumps may support the reinforcing apparatus on the packaging substrate, the distance between the bonding plane and the packaging substrate is also definite. This helps accurately control a thickness of the insulating adhesive between the bonding plane and the packaging substrate, and resolves packaging reliability problems caused by inaccurate control on the thickness of the insulating adhesive, for example, a problem of a large stress caused by a thin insulating adhesive, and a problem of serious warpage of a packaging structure caused by a thick insulating adhesive.

### BRIEF DESCRIPTION OF DRAWINGS

To clearly understand specific implementations of this application, the following briefly describes accompanying drawings used for describing the specific implementations of this application. It is clearly that the accompanying drawings show merely some embodiments of this application.
FIG. 1 is a top view of a packaging structure according to an embodiment of this application;
FIG. 2 is a sectional view of the packaging structure in FIG. 1 along an AA direction;
FIG. 3 is a top view of another packaging structure according to an embodiment of this application;
FIG. 4 is a top view of still another packaging structure according to an embodiment of this application;
FIG. 5 is a schematic diagram of detection of the packaging structure in FIG. 4 at different positions;
FIG. 6 is a schematic diagram of a heat dissipation lid according to an embodiment of this application;
FIG. 7 is a flowchart of a packaging method according to an embodiment of this application; and
FIG. 8 is a schematic diagram of a packaging structure in a packaging process according to an embodiment of this application.

### DESCRIPTION OF EMBODIMENTS

Embodiments of this application provide a packaging structure, a packaging method, an electronic apparatus, and a manufacturing method thereof, to relieve warpage of a packaging substrate, control an internal stress of the packaging structure, and improve reliability of the packaging structure.

In this specification, claims, and the foregoing accompanying drawings of this application, the terms "first", "second", "third", "fourth", and the like (if existent) are intended to distinguish between similar objects but do not necessarily indicate a specific order or sequence. It should be understood that the data termed in such a way are interchangeable in proper circumstances so that embodiments described herein can be implemented in other orders than the order illustrated or described herein. In addition, the terms "include" and "have" and any other variants are intended to cover a non-exclusive inclusion. For example, a process, method, system, product, or device that includes a list of steps or units is not necessarily limited to those expressly listed steps or units, but may include other steps or units not expressly listed or inherent to such a process, method, product, or device.

This application is described in detail with reference to the schematic diagrams. When embodiments of this application are described in detail, for ease of description, a sectional view illustrating a component structure is not partially enlarged according to a general proportion. In addition, the schematic diagrams are merely examples and should not limit the protection scope of this application. Moreover, the length, width, and depth of a three-dimensional space should be included in actual manufacture.

After a chip is packaged on a packaging substrate, a mismatch of coefficients of thermal expansion between the chip and the packaging substrate may easily cause packaging warpage, the packaging warpage may easily cause problems such as solder bridging and open soldering in a connection between the chip and the packaging substrate, and a connection end of the chip is generally led out by using the packaging substrate, so the problems such as solder bridging and open soldering may easily cause a failure in leading out the connection end of the chip, which seriously affects a yield of a surface mounted technology.

In order to control packaging thermal deformation, a reinforcing apparatus may be disposed on the packaging substrate. The reinforcing apparatus may be fastened to the packaging substrate, so as to relieve the warpage of the packaging substrate. Specifically, the reinforcing apparatus may be bonded to the packaging substrate by using insulating adhesive (AD). However, the reinforcing apparatus may increase an internal stress of the packaging structure while relieving the warpage of the packaging substrate, and a problem such as layering or fracture may easily occur at a position with a large stress. Therefore, reliability of the packaging structure is low.

By studies, the inventors found that the reliability of the packaging structure is low, because in the current packaging process, a side, facing the packaging substrate, of the reinforcing apparatus has a bonding plane, insulating adhesive is disposed between the bonding plane and the packaging substrate, and the insulating adhesive between the reinforcing apparatus and the packaging substrate may be extruded by extruding the reinforcing apparatus and the packaging substrate, so as to reduce the thickness of the insulating adhesive, where a manner of controlling the thickness of the insulating adhesive is force control to minimize the thickness of the insulating adhesive and bond the bonding plane and the packaging substrate, but this manner is unlikely to accurately control the thickness of the insulating adhesive and evenness of the thickness.

However, in the packaging structure, when the insulating adhesive is thick, a degree of coupling between thermal deformation of the reinforcing apparatus and thermal deformation of the packaging substrate is low, and a function of the reinforcing apparatus for relieving warpage is not fully exerted, so a problem of serious warpage is caused, which affects a packaging yield. When the insulating adhesive is thin, a degree of coupling between thermal deformation of the reinforcing apparatus and thermal deformation of the packaging substrate is high, a mismatch of coefficients of thermal expansion between the reinforcing apparatus and the packaging substrate is reflected, and the thermal deformation of the reinforcing apparatus acts on the packaging substrate, causing stress of the packaging substrate to increase and potential risks of fracture and layering, thereby reducing reliability of the packaging structure. That is, the thickness of the insulating adhesive is important to the reliability of the packaging structure. A proper thickness of the insulating adhesive helps ensure packaging stress reliability and effectively control warpage to ensure a soldering yield. However, in the current packaging process, the thickness and evenness of the insulating adhesive cannot be accurately controlled, which is not conducive to improving reliability of the packaging structure.

Based on the above technical problems, embodiments of this application provide a packaging structure, a packaging method, an electronic apparatus, and a manufacturing method thereof. The packaging structure includes a packaging substrate, a chip, and a reinforcing apparatus, where the chip is fastened to the packaging substrate, the reinforcing apparatus is fastened to the packaging substrate at a periphery of the chip, the reinforcing apparatus includes at least a ring structure that transversely surrounds the chip, a side, facing the packaging substrate, of the reinforcing apparatus has a bonding plane and a plurality of bumps protruding out of the bonding plane, the plurality of bumps are disposed at different positions of the ring structure to support the reinforcing apparatus on the packaging substrate, and the bonding plane and the packaging substrate are bonded by using insulating adhesive. Because the height difference between the bonding plane and the bumps is definite, and the bumps may support the reinforcing apparatus on the packaging substrate, the distance between the bonding plane and the packaging substrate is also definite. This helps accurately control a thickness of the insulating adhesive between the bonding plane and the packaging substrate, and resolves packaging reliability problems caused by inaccurate control on the thickness of the insulating adhesive, for example, a problem of a large stress caused by a thin insulating adhesive, and a problem of serious warpage of a packaging structure caused by a thick insulating adhesive.

To make the objectives, features, and advantages of this application more apparent and understandable, the following describes specific implementations of this application in detail with reference to the accompanying drawings.

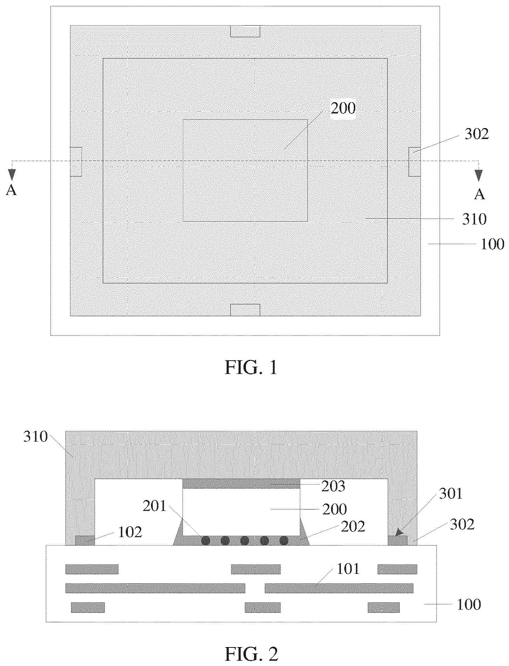

FIG. 1 is a top view of a packaging structure according to an embodiment of this application. FIG. 2 is a sectional view of the packaging structure in FIG. 1 along an AA direction. The packaging structure may include a packaging substrate 100, a chip 200, and a reinforcing apparatus 310.

In this embodiment of this application, the chip 200 is a product form in which a semiconductor component is manufactured but not packaged, may be in a die form, and may be referred to as a bare chip. A packaging structure is formed after packaging. The packaging structure may be used as a component of a semiconductor component, an integrated circuit, or a more complex circuit (hybrid circuit). The chip 200 may be a semiconductor chip, and may be a silicon (Si) chip, a germanium (Ge) chip, a silicon-germanium (SiGe) chip, or the like. For example, the chip 200 is a silicon chip, and a coefficient of thermal expansion thereof is 2.5 to 3.5.

The chip 200 may be fastened to the packaging substrate 100. The packaging substrate 100 and the chip 200 may be connected in a flip chip ball grid array (FCBGA) packaging form. That is, the chip 200 may be fastened to the packaging substrate 100 in a flip form. An active surface of the chip 200 faces the packaging substrate 100. A lead-out end may be further formed on a front surface of the chip 200, to implement an electrical connection with another circuit structure through the packaging substrate 100. One or more chips 200 may be fastened to the packaging substrate 100. In the figures, one chip 200 is used as an example for description.

The packaging substrate 100 is a semiconductor substrate with high mechanical strength, which can thus improve overall mechanical strength of the packaging structure. An interconnection structure 101 may be formed in the packaging substrate 100. The interconnection structure 101 may include a conductor layer, a conductor pad, a conductive through hole, and the like. It should be noted that the interconnection structure 101 connects an upper surface and a lower surface of the packaging substrate. After simplification, only the interconnection structure 101 located inside the packaging substrate 100 is shown. Actually, the interconnection structure 101 is also formed on the upper surface and the lower surface of the packaging substrate. A solder ball 201 may be formed between the chip 200 and the packaging substrate 100, and the solder ball 201 is used for connecting the lead-out end of the chip 200 and the interconnection structure 101 located on the upper surface of the packaging substrate 100, so as to implement an electrical connection between the chip 200 and the packaging substrate 100. In addition, a bottom filling adhesive 202 may be further filled between the chip 200 and the packaging substrate 100. The bottom filling adhesive 202 may be a non-conductive adhesive, for example, an epoxy resin (epoxy).

The packaging structure may be fastened to a printed circuit board (not shown in the figures) to form an electronic apparatus including the packaging structure and the printed circuit board, where the packaging substrate 100 may be connected to the printed circuit board. The packaging substrate 100 may be connected to the printed circuit board by the solder ball between them. The solder ball may be connected to the interconnection structure 101 located on the lower surface of the packaging substrate 100, so that the printed circuit board and the chip 200 are electrically connected by using the packaging substrate 100.

The chip 200 and the packaging substrate 100 may have different coefficients of thermal expansion. Therefore, in a packaging process, different thermal deformation is easily caused due to impact of a temperature. For example, a high temperature is generated in a process of forming a solder ball, the coefficient of thermal expansion of the packaging substrate 100 is large and is about 14 to 17, and the packaging substrate 100 has obvious thermal deformation and is easily warped. On this basis, a reinforcing apparatus 310 may be further formed on the packaging substrate 100. The reinforcing apparatus 310 is fastened to the packaging substrate 100 at the periphery of the chip 200. The reinforcing apparatus 310 is of a rigid structure, and the packaging substrate 100 is fixed based on structural stability of the reinforcing apparatus 310, so as to relieve warpage of a packaging component.

The reinforcing apparatus 310 includes at least a ring structure that transversely surrounds the chip 200. The ring structure may be a circular ring or a polygonal ring, and the polygonal ring may be a rectangular ring, a hexagonal ring, or the like. When there are a plurality of chips 200, each ring structure may surround only one chip 200, or may surround the plurality of chips 200 at the same time. A side, facing the packaging substrate 100, of the reinforcing apparatus 310 has a bonding plane 301 and a plurality of bumps 302/303 protruding out of the bonding plane 301. The bonding plane 301 may be parallel to the surface of the packaging substrate 100, or may be at an angle with the surface of the packaging substrate 100. The bump 302/303 may have a surface parallel to the surface of the packaging substrate 100, so that the bump 302/303 may have an even height relative to the bonding plane 301. The bump 302/303 may also have a surface at an angle with the surface of the packaging substrate 100 or an uneven surface, so that the bump 302/303 may have an uneven height relative to the bonding plane 301. A side wall of the bump 302/303 and the bonding plane 301 may be perpendicular, or may be at an acute angle or an obtuse angle.

The plurality of bumps 302/303 in the reinforcing apparatus 310 may be disposed at different positions of the ring structure to support the reinforcing apparatus 310 on the packaging substrate 100. Specifically, there may be two bumps 302/303, and the bumps 302/303 are parallel to the surface of the packaging substrate 100 to support the reinforcing apparatus 310, or there may be three, four, or eight bumps 302/303 to form a support structure. Projections of the bumps 302/303 on the surface of the packaging substrate may be in at least one of the following shapes: a polygon, a circle, an ellipse, an L shape, a cross shape, and the like. The projections of the bumps 302/303 may be in a same shape or in different shapes. The polygon may be a rectangle or a trapezoid.

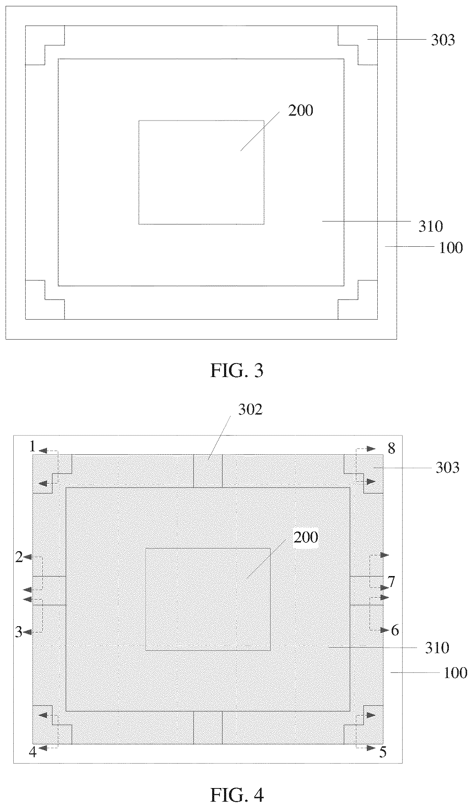

The bumps 302/303 in the reinforcing apparatus 310 are used for supporting the reinforcing apparatus 310 on the packaging substrate 100, and positions of the bumps 302/303 may be determined according to a force condition of each position of the reinforcing apparatus 310. Specifically, when the ring structure is a rectangular ring structure, the bumps may be disposed at corners of the rectangular ring structure. FIG. 3 is a top view of another packaging structure according to an embodiment of this application. The bumps may include four first bumps 303 disposed at four corners of the rectangular ring structure. The bumps may also be disposed on sides of the rectangular ring structure. For example, the bumps may include four second bumps 302 disposed on four sides of the rectangular ring structure, and the second bumps 302 on the sides of the rectangular ring structure may be located at central positions of the sides, as shown in FIG. 1. Alternatively, the bumps may be disposed at corners of and on sides of the rectangular ring structure. FIG. 4 is a top view of still another packaging structure according to an embodiment of this application. The bumps may include four first bumps 303 disposed at four corners of the rectangular ring structure and four second bumps 302 disposed on four sides of the rectangular ring structure, to constitute eight bumps 302/303. The four first bumps 303 disposed at the four corners of the rectangular ring structure may be of L-shaped structures, and the four second bumps 302 disposed on the four sides of the rectangular ring structure may be of rectangular structures. Widths of the first bumps 303 and the second bumps 302 may be less than a side width of the rectangular ring structure, as shown in FIG. 1. Widths of the second bumps 302 may also be equal to the side width of the rectangular ring structure, as shown in FIG. 4. Of course, the widths of the first bumps 303 may also be equal to the side width of the rectangular ring structure, which is not illustrated herein.

The plurality of bumps 302/303 may have approximately a same height. Generally, the plurality of bumps 302/303 have a same design height. Due to machining errors, the actually obtained bumps 302/303 may have different heights within an allowable range. When supporting the reinforcing apparatus 310, the plurality of bumps 302/303 need to be in contact with the packaging substrate 100. Of course, the plurality of bumps 302/303 may all be in contact with the packaging substrate 100. Alternatively, some of the bumps may be in contact with the packaging substrate 100. For example, when there are eight bumps 302/303, seven of the bumps may be in contact with the packaging substrate 100. When the bump 302/303 has a plane parallel to the packaging substrate 100, a contact surface of the bump 302/303 in contact with the packaging substrate 100 may be an entire protruding plane. When the bump 302/303 has a plane not parallel to the packaging substrate 100, a contact surface of the bump 302/303 in contact with the packaging substrate 100 may be a partial protruding plane.

The bonding plane 301 in the reinforcing apparatus 310 is bonded to the packaging substrate 100 by using insulating adhesive 102. The insulating adhesive 102 may cover all of the bonding plane 301, or may cover a part of the bonding plane 301. Because the bump 302/303 is in contact with the packaging substrate 100, the distance between the bonding plane 301 and the packaging substrate 100 is determined by a height of the bump 302/303, and the thickness of the insulating adhesive 102 between the bonding plane 301 and the packaging substrate 100 is also determined by the height of the bump 302/303. The height of the bump 302/303 is determined by a manufacturing process. Therefore, the thickness of the insulating adhesive 102 may also be accurately controlled by the manufacturing process. In a process of fastening the packaging substrate 100 and the reinforcing apparatus 310, the insulating adhesive 102 may be press-fitted, fixed and cured through pressure control and temperature, so that the insulating adhesive 102 is formed between the bonding plane 301 and the packaging substrate 100, and the reinforcing apparatus 310 is connected to the packaging substrate 100.

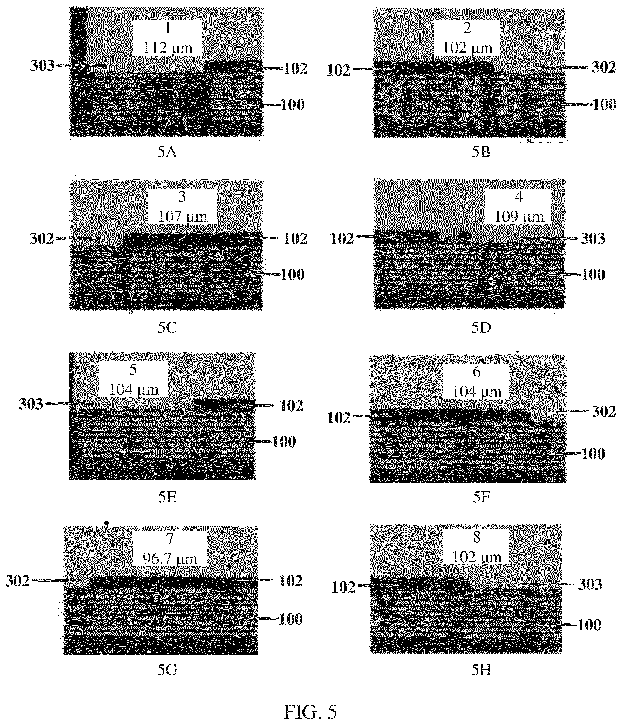

A height range of the bump 302/303 relative to the bonding plane 301 may be determined according to a thickness of the insulating adhesive 102 that is actually required. In an actual operation, for different packaging structures, bumps 302/303 of different heights may be disposed to meet requirements in different scenarios. Specifically, the height range of the bumps 302/303 relative to the bonding plane 301 may be 10 micrometers to 300 micrometers. In this embodiment of this application, the height of the bump 302/303 is 100 micrometers is used as an example for testing. FIG. 5 is a schematic diagram of detection of the packaging structure in FIG. 4 at different positions, where the height of the bump 302/303 is designed to be 100 micrometers. FIG. 5A to FIG. 5H are sectional detection diagrams of the packaging structure in FIG. 4 in directions 1, 2, 3, 4, 5, 6, 7, and 8, respectively. It can be seen that the insulating adhesive 102 has a thickness of 112 µm at position 1 in FIG. 5A, a thickness of 102 µm at position 2 in FIG. 5B, a thickness of 107 µm at position 3 in FIG. 5C, a thickness of 109 µm at position 4 in FIG. 5D, a thickness of 104 µm at position 5 in FIG. 5E, a thickness of 104 µm at position 6 in FIG. 5F, a thickness of 96.7 µm at position 7 in FIG. 5G, and a thickness of 102 µm at position 8 in FIG. 5H. Hence, the thickness of the insulating adhesive 102 is distributed within a range of 100±15 µm, which is close to the designed height value 100 µm of the bump 302/303, so the thickness of the insulating adhesive can be accurately controlled.

In this embodiment of this application, the reinforcing apparatus 310 may have good structural stability. A material of the reinforcing apparatus 310 may be a metal material or a non-metal material with high strength. The metal material may be, for example, copper, aluminum, chrome-plated copper, chrome-plated aluminum, nickel-plated copper, or nickel-plated aluminum. A coefficient of thermal expansion of the metal material may be 10 to 25.

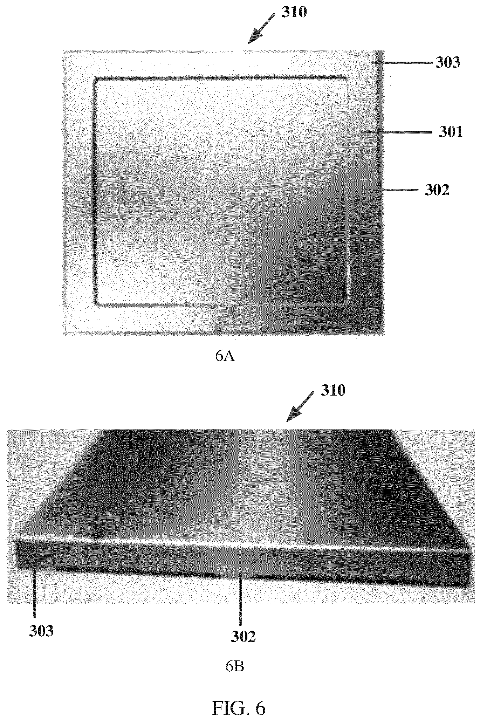

The reinforcing apparatus 310 may be a heat dissipation lid or a reinforcing ring. The reinforcing ring includes a ring structure that transversely surrounds the chip 200, and a top of the chip 200 is not covered by the ring structure, so as to provide stress for the packaging substrate 100 laterally to relieve warpage of the packaging substrate 100. The reinforcing ring may further include a reinforcing side wall inside the ring structure or a reinforcing side wall outside the ring structure, to further improve structural stability of the packaging substrate 100. In addition to the ring structure that transversely surrounds the chip 200, the heat dissipation lid may further include a heat dissipation plane connected to the ring structure. The heat dissipation plane may be located above the chip 200 to dissipate heat for the chip 200. Of course, the heat dissipation plane may also be located above the ring structure, the ring structure supports the heat dissipation plane, and the ring structure and the heat dissipation plane may be of an integrated structure. Therefore, the heat dissipation lid can provide stress for the packaging substrate 100 laterally to relieve warpage of the packaging substrate 100, and can dissipate heat for the packaging structure, so as to further reduce thermal deformation and stress inside the packaging structure. FIG. 6 is a schematic diagram of a heat dissipation lid according to an embodiment of this application. FIG. 6A is a schematic diagram of a heat dissipation lid provided with bumps 302/303 on one side, and FIG. 6B is a side view of the heat dissipation lid.

The heat dissipation plane of the heat dissipation lid may dissipate heat for the chip 200, and a thermal interface material (TIM) 203 may be further disposed between the heat dissipation plane and the chip 200. The thermal interface material 203 has good heat conduction, and may conduct heat generated by the chip 200 to the heat dissipation plane of the heat dissipation lid, so as to implement heat dissipation of the chip 200. When the heat dissipation lid surrounds a plurality of chips 200 at the same time, the thermal interface material 203 may be formed between the heat dissipation lid and each chip 200. The heat dissipation lid needs to have good heat conduction performance, and therefore may be made of a metal material, for example, copper. The thermal interface material 203 may be a colloid including thermally conductive particles. The thermally conductive particles may include at least one of zinc oxide, aluminum oxide, aluminum nitride, boron nitride, a ceramic filler, and the like. The colloid may be silica gel.

The bumps 302/303 and the bonding plane 301 in the reinforcing apparatus 310, which may be obtained by a process such as forging, only need to be designed in a manufacturing process of the reinforcing apparatus 310, so controllability on the thickness of the insulating adhesive 102 can be improved without increasing complexity of an existing packaging process, the operation is easy, and packaging reliability problems caused by inaccurate control on the thickness of the insulating adhesive 102 are resolved.

This embodiment of this application provides a packaging structure, including a packaging substrate, a chip, and a reinforcing apparatus, where the chip is fastened to the packaging substrate, the reinforcing apparatus is fastened to the packaging substrate at a periphery of the chip, the reinforcing apparatus includes at least a ring structure that transversely surrounds the chip, a side, facing the packaging substrate, of the reinforcing apparatus has a bonding plane and a plurality of bumps protruding out of the bonding plane, the plurality of bumps are disposed at different positions of the ring structure to support the reinforcing apparatus on the packaging substrate, and the bonding plane and the packaging substrate are bonded by using insulating adhesive. Because the height difference between the bonding plane and the bumps is definite, and the bumps may support the reinforcing apparatus on the packaging substrate, the distance between the bonding plane and the packaging substrate is also definite. This helps accurately control a thickness of the insulating adhesive between the bonding plane and the packaging substrate, and resolves packaging reliability problems caused by inaccurate control on the thickness of the insulating adhesive, for example, a problem of a large stress caused by a thin insulating adhesive, and a problem of serious warpage of a packaging structure caused by a thick insulating adhesive.

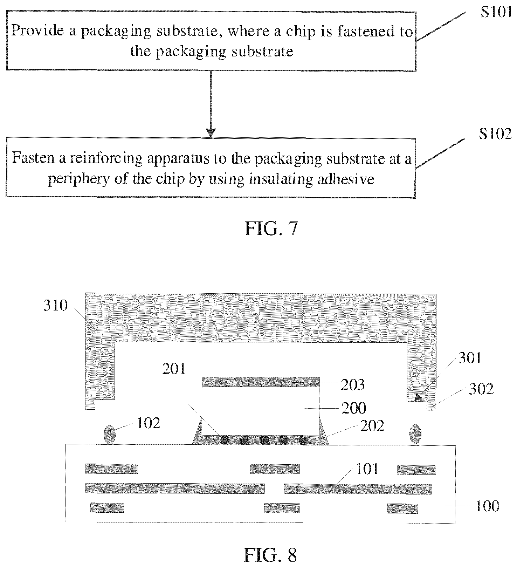

Based on the packaging structure provided in the foregoing embodiment, an embodiment of this application further provides a packaging method. FIG. 7 is a flowchart of a packaging method according to an embodiment of this application. FIG. 8 is a schematic diagram of a packaging structure in a packaging process according to an embodiment of this application. The packaging method may include:

S101: Provide a packaging substrate, where a chip is fastened to the packaging substrate, as shown in FIG. 8.

In this embodiment of this application, the chip 200 is a product form in which a semiconductor component is manufactured but not packaged, may be in a die form, and may be referred to as a bare chip. A packaging structure is formed after packaging. The packaging structure may be used as a component of a semiconductor component, an integrated circuit, or a more complex circuit (hybrid circuit). The chip 200 may be a semiconductor chip, and may be a silicon (Si) chip, a germanium (Ge) chip, a silicon-germanium (SiGe) chip, or the like. For example, the chip 200 is a silicon chip, and a coefficient of thermal expansion of the chip is 2.5 to 3.5.

The chip 200 may be fastened to the packaging substrate 100. The packaging substrate 100 and the chip 200 may be connected in a flip chip ball grid array (FCBGA) packaging form. To be specific, the chip 200 may be fastened to the packaging substrate 100 in a flip form. An active surface of the chip 200 faces the packaging substrate 100. A lead-out end may be further formed on a front surface of the chip 200, to implement an electrical connection with another circuit structure by using the packaging substrate 100. One or more chips 200 may be fastened to the packaging substrate 100. In the figures, one chip 200 is used as an example for description.

The packaging substrate 100 is a semiconductor substrate with high mechanical strength, which can thus improve overall mechanical strength of the packaging structure. An interconnection structure 101 may be formed in the packaging substrate 100. The interconnection structure 101 may include a conductor layer, a conductor pad, a conductive through hole, and the like. It should be noted that the interconnection structure 101 connects an upper surface and a lower surface of the packaging substrate. After simplification, only the interconnection structure 101 located inside the packaging substrate 100 is shown. Actually, the interconnection structure 101 is also formed on the upper surface and the lower surface of the packaging substrate. A solder ball 201 may be formed between the chip 200 and the packaging substrate 100, and the solder ball 201 is used for connecting the lead-out end of the chip 200 and the interconnection structure 101 located on the upper surface of the packaging substrate 100, so as to implement an electrical connection between the chip 200 and the packaging substrate 100. In addition, a bottom filling adhesive 202 may be further filled between the chip 200 and the packaging substrate 100. The bottom filling adhesive 202 may be a non-conductive adhesive, for example, an epoxy resin (epoxy).

The chip 200 and the packaging substrate 100 may have different coefficients of thermal expansion. Therefore, in a packaging process, different thermal deformation is easily caused due to impact of a temperature. For example, a high temperature is generated in a process of forming a solder ball, the coefficient of thermal expansion of the packaging substrate 100 is large and is about 14 to 17, and the packaging substrate 100 has obvious thermal deformation and is easily warped. For example, an edge position of the packaging substrate is bent downward.

S102: Fasten the reinforcing apparatus 310 to the packaging substrate at a periphery of the chip by using insulating adhesive.

In this embodiment of this application, the reinforcing apparatus 310 may be further formed on the packaging substrate 100, and the reinforcing apparatus 310 is fastened to the packaging substrate 100 at the periphery of the chip 200. The reinforcing apparatus 310 is of a rigid structure, and the packaging substrate 100 is fixed based on structural stability of the reinforcing apparatus 310, so as to relieve warpage of a packaging component. The reinforcing apparatus 310 includes at least a ring structure that transversely surrounds the chip 200, and the ring structure may be a circular ring or a polygonal ring. When there are a plurality of chips 200, each ring structure may surround only one chip 200, or may surround the plurality of chips 200 at the same time. The side, facing the packaging substrate 100, of the reinforcing apparatus 310 has a bonding plane 301 and a plurality of bumps 302/303 protruding out of the bonding plane 301.

The plurality of bumps 302/303 in the reinforcing apparatus 310 may be disposed at different positions of the ring structure to support the reinforcing apparatus 310 on the packaging substrate 100. Specifically, there may be two, three, four, or eight bumps 302/303 to form a support structure. Projections of the bumps 302/303 on the surface of the packaging substrate may be in at least one of the following shapes: a polygon, a circle, an ellipse, an L shape, a cross shape, and the like. The projections of the bumps 302/303 may be in a same shape or in different shapes. The polygon may be a rectangle or a trapezoid. When the ring structure is a rectangular ring structure, the bumps may be disposed at corners of the rectangular ring structure, or may be disposed on sides of the rectangular ring structure, or may be disposed at corners of and on sides of the rectangular ring structure.

The plurality of bumps 302/303 may have approximately a same height. Generally, the plurality of bumps 302/303 have a same design height. Due to machining errors, the actually obtained bumps 302/303 may have different heights within an allowable range. When supporting the reinforcing apparatus 310, the plurality of bumps 302/303 need to be in contact with the packaging substrate 100. Of course, the plurality of bumps 302/303 may all be in contact with the packaging substrate 100. Alternatively, some of the bumps may be in contact with the packaging substrate 100. For example, when there are eight bumps 302/303, seven of the bumps may be in contact with the packaging substrate 100.

The bonding plane 301 in the reinforcing apparatus 310 is used for being bonded to the packaging substrate 100. Because the bump 302/303 is in contact with the packaging substrate 100, the distance between the bonding plane 301 and the packaging substrate 100 is determined by the height of the bump 302/303, and the thickness of the insulating adhesive 102 for bonding between the bonding plane 301 and the packaging substrate 100 is also determined by the height of the bump 302/303. The height of the bump 302/303 is determined by a manufacturing process. Therefore, the thickness of the insulating adhesive 102 may also be accurately controlled by the manufacturing process.

In this embodiment of this application, the insulating adhesive 102 may be formed at a position of the packaging substrate 100 corresponding to the bonding plane 301, and then the reinforcing apparatus 310 is press-fitted on the packaging substrate 100 in a pressure control manner, so that the bumps 302/303 support the reinforcing apparatus 310 on the packaging substrate 100, the insulating adhesive 102 between the bonding plane 301 and the packaging substrate 100 is extruded, the bonding plane 301 and the packaging substrate 100 are bonded by using the insulating adhesive 102, and the insulating adhesive 102 may be fixed and cured through temperature control. In this process, the position of the insulating adhesive on the packaging substrate 100 is controlled, so that the insulating adhesive 102 can be formed between the packaging substrate 100 and the bonding plane 301 after being press-fitted, but not between the packaging substrate 100 and the bumps 302/303. Of course, even if a trace amount of the insulating adhesive 102 is formed between the bump 302/303 and the packaging substrate 100, implementation of this embodiment of this application is not affected.

The thickness of the insulating adhesive 102 is related to the height of the bumps 302/303 relative to the bonding plane 301, so in an actual operation, for different packaging structures, bumps 302/303 of different heights may be disposed to meet requirements in different scenarios. Specifically, a height range of the bumps 302/303 relative to the bonding plane 301 may be 10 micrometers to 300 micrometers.

In this embodiment of this application, the reinforcing apparatus 310 may have good structural stability. A material of the reinforcing apparatus 310 may be a metal material or a non-metal material with high strength. The metal material may be, for example, copper, aluminum, chrome-plated copper, chrome-plated aluminum, nickel-plated copper, or nickel-plated aluminum. A coefficient of thermal expansion of the metal material may be 10 to 25. The reinforcing apparatus 310 may be a heat dissipation lid or a reinforcing ring. The reinforcing ring includes a ring structure that transversely surrounds the chip 200, and a top of the chip 200 is not covered by the ring structure, so as to provide stress for the packaging substrate 100 laterally to relieve warpage of the packaging substrate 100. In addition to the ring structure that transversely surrounds the chip 200, the heat dissipation lid may further include a heat dissipation plane connected to the ring structure. The heat dissipation plane may be located above the chip 200 to dissipate heat for the chip 200. The ring structure and the heat dissipation plane may be of an integrated structure. Therefore, the heat dissipation lid can provide stress for the packaging substrate 100 laterally to relieve warpage of the packaging substrate 100, and can dissipate heat for the packaging structure, so as to further reduce thermal deformation and stress inside the packaging structure.

The heat dissipation plane of the heat dissipation lid may dissipate heat for the chip 200, and a thermal interface material 203 may be further disposed between the heat dissipation plane and the chip 200. The thermal interface material 203 has good heat conduction, and may conduct heat generated by the chip 200 to the heat dissipation plane of the heat dissipation lid, so as to implement heat dissipation of the chip 200. When the heat dissipation lid surrounds a plurality of chips 200 at the same time, the thermal interface material 203 may be formed between the heat dissipation lid and each chip 200. The heat dissipation lid needs to have good heat conduction performance, and therefore may be made of a metal material, for example, copper. The thermal interface material 203 may be a colloid including thermally conductive particles. The thermally conductive particles may include at least one of zinc oxide, aluminum oxide, aluminum nitride, boron nitride, a ceramic filler, and the like. The colloid may be silica gel. That is, before the reinforcing apparatus 310 is fastened to the packaging substrate 100, the thermal interface material 203 may be formed on an upper surface of the chip 200. In a press-fitting process of fastening the reinforcing apparatus 310 to the packaging substrate 100, the thermal interface material 203 is extruded and cured.

After the reinforcing apparatus 310 is fastened to the packaging substrate 100, the packaging structure may be fastened to a printed circuit board (not shown in the figures) to form an electronic apparatus including the packaging structure and the printed circuit board, where the packaging substrate 100 may be connected to the printed circuit board. The packaging substrate 100 may be connected to the printed circuit board by a solder ball between them. The solder ball may be connected to the interconnection structure 101 located on the lower surface of the packaging substrate 100, so that the printed circuit board and the chip 200 are electrically connected by using the packaging substrate 100.

This embodiment of this application provides a packaging method, including: providing a packaging substrate, where a chip is fastened to the packaging substrate; and fastening a reinforcing apparatus to the packaging substrate by using insulating adhesive, where the reinforcing apparatus is fastened to the packaging substrate at a periphery of the chip, the reinforcing apparatus includes at least a ring structure that transversely surrounds the chip, a side, facing the packaging substrate, of the reinforcing apparatus has a bonding plane and a plurality of bumps protruding out of the bonding plane, the plurality of bumps are disposed at different positions of the ring structure to support the reinforcing apparatus on the packaging substrate, and the bonding plane and the packaging substrate are bonded by using the insulating adhesive. Because the height difference between the bonding plane and the bumps is definite, and the bumps may support the reinforcing apparatus on the packaging substrate, the distance between the bonding plane and the packaging substrate is also definite. This helps accurately control a thickness of the insulating adhesive between the bonding plane and the packaging substrate, and resolves packaging reliability problems caused by inaccurate control on the thickness of the insulating adhesive, for example, a problem of a large stress caused by a thin insulating adhesive, and a problem of serious warpage of a packaging structure caused by a thick insulating adhesive.

Embodiments in this specification are all described in a progressive manner. For same or similar parts in embodiments, mutual reference may be made. Each embodiment focuses what is different from other embodiments. In particular, the method embodiment is basically similar to the structure embodiment, and therefore is described briefly. For related parts, refer to partial descriptions in the structure embodiment.

The foregoing provides specific implementations of this application. It should be understood that the foregoing embodiments are merely intended for describing the technical solutions of this application, but not for limiting this application. Although this application is described in detail with reference to the foregoing embodiments, those of ordinary skill in the art should understand that they may still make modifications to the technical solutions described in the foregoing embodiments or make equivalent replacements to some technical features thereof, without departing from the scope of the technical solutions of embodiments of this application.

## Claims

1. A packaging structure, comprising:
a packaging substrate;
a chip, wherein the chip is fastened to the packaging substrate; and
a reinforcing apparatus, wherein the reinforcing apparatus is fastened to the packaging substrate at a periphery of the chip, the reinforcing apparatus comprises at least a ring structure that transversely surrounds the chip, a side, facing the packaging substrate, of the reinforcing apparatus has a bonding plane and a plurality of bumps protruding out of the bonding plane, the plurality of bumps are disposed at different positions of the ring structure to support the reinforcing apparatus on the packaging substrate, and the bonding plane and the packaging substrate are bonded by using insulating adhesive.

2. The packaging structure according to claim 1, wherein the ring structure is a rectangular ring structure; and the bumps are located at corners of the rectangular ring structure, and/or are located on sides of the rectangular ring structure.

3. The packaging structure according to claim 1 or 2, wherein projections of the bumps on a surface of the packaging substrate are in at least one of the following shapes: a polygon, a circle, an ellipse, an L shape, and a cross shape.

4. The packaging structure according to any one of claims 1 to 3, wherein a height range of the bumps relative to the bonding plane is 10 micrometers to 300 micrometers.

5. The packaging structure according to any one of claims 1 to 4, wherein the reinforcing apparatus further comprises a heat dissipation plane connected to the ring structure, and the heat dissipation plane is located above the chip and is used for dissipating heat for the chip.

6. The packaging structure according to claim 5, wherein a thermal interface material is disposed between the heat dissipation plane and the chip.

7. The packaging structure according to claim 6, wherein the thermal interface material is a colloid comprising thermally conductive particles, and the thermally conductive particles comprise at least one of zinc oxide, aluminum oxide, aluminum nitride, boron nitride, and a ceramic filler.

8. The packaging structure according to any one of claims 1 to 7, wherein a flip chip ball grid array packaging form is used between the packaging substrate and the chip.

9. An electronic apparatus, comprising:
a printed circuit board and the packaging structure according to any one of claims 1 to 8, wherein the packaging substrate is fastened to the printed circuit board, and the printed circuit board and a chip are electrically connected by using the packaging substrate.

10. A packaging method, comprising:
providing a packaging substrate, wherein a chip is fastened to the packaging substrate; and
fastening a reinforcing apparatus to the packaging substrate at a periphery of the chip by using insulating adhesive, wherein the reinforcing apparatus comprises at least a ring structure that transversely surrounds the chip, a side, facing the packaging substrate, of the reinforcing apparatus has a bonding plane and a plurality of bumps protruding out of the bonding plane, the plurality of bumps are disposed at different positions of the ring structure to support the reinforcing apparatus on the packaging substrate, and the bonding plane and the packaging substrate are bonded by using the insulating adhesive.

11. The method according to claim 10, wherein the fastening a reinforcing apparatus to the packaging substrate at a periphery of the chip by using insulating adhesive comprises:
forming the insulating adhesive at a position of the packaging substrate corresponding to the bonding plane; and
press-fitting the reinforcing apparatus to the packaging substrate in a pressure control manner, so that the bumps support the reinforcing apparatus on the packaging substrate, and the bonding plane and the packaging substrate are bonded by using the insulating adhesive.

12. The method according to claim 10 or 11, wherein the ring structure is a rectangular ring structure; and the bumps are located at corners of the rectangular ring structure, and/or are located on sides of the rectangular ring structure.

13. The method according to any one of claims 10 to 12, wherein projections of the bumps on a surface of the packaging substrate are in at least one of the following shapes: a polygon, a circle, an ellipse, an L shape, and a cross shape.

14. The method according to any one of claims 10 to 13, wherein a height range of the bumps relative to the bonding plane is 10 micrometers to 300 micrometers.

15. The method according to any one of claims 10 to 14, wherein the reinforcing apparatus further comprises a heat dissipation plane connected to the ring structure, and the heat dissipation plane is located above the chip and is used for dissipating heat for the chip.

16. The method according to any one of claims 10 to 15, wherein a thermal interface material is disposed between the heat dissipation plane and the chip.

17. The method according to claim 16, wherein the thermal interface material is a colloid comprising thermally conductive particles, and the thermally conductive particles comprise at least one of zinc oxide, aluminum oxide, aluminum nitride, boron nitride, and a ceramic filler.

18. The method according to any one of claims 10 to 17, wherein a flip chip ball grid array packaging form is used between the packaging substrate and the chip.

19. A manufacturing method for an electronic apparatus, comprising:
fastening the packaging substrate in the packaging structure according to any one of claims 1 to 8 to a printed circuit board, wherein the printed circuit board and the chip are electrically connected by using the packaging substrate.
